(19) Europäisches Patentamt
European Patent Office
Office européen des brevets

(11) EP 3 160 049 A1

(12) EUROPEAN PATENT APPLICATION

(43) Date of publication:
**26.04.2017 Bulletin 2017/17**

(51) Int Cl.:
***H03M 7/14*** *(2006.01)* ***H03M 13/33*** *(2006.01)*
***H03M 13/37*** *(2006.01)*

(21) Application number: **15306666.7**

(22) Date of filing: **19.10.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(71) Applicant: **Thomson Licensing**
**92130 Issy-les-Moulineaux (FR)**

(72) Inventors:
- **Blawat, Meinolf**
  **30659 Hannover (DE)**
- **Huetter, Ingo**
  **30982 Pattensen (DE)**
- **Gaedke, Klaus**
  **30659 Hannover (DE)**
- **Chen, Xiaoming**
  **30659 Hannover (DE)**

(74) Representative: **Huchet, Anne et al**
**TECHNICOLOR**
**1-5, rue Jeanne d'Arc**
**92130 Issy-les-Moulineaux (FR)**

# (54) DATA PROCESSING METHOD AND DEVICE FOR RECOVERING VALID CODE WORDS FROM A CORRUPTED CODE WORD SEQUENCE

(57) Code word sequences obtained from data transmission/storage channels, e.g. nucleic acid storage systems, encounter code symbol insertion and deletion errors. A data processing device (80) recovers valid code words from corrupted code word sequences. The valid code words belong to at least one code book of channel modulated code words of identical length. A code word sequence is obtained (51), presumed code word boundaries for the sequence are determined (52) depending on the identical length, code words corresponding with the boundaries are compared (53) with the code book to identify valid code words, and a section of the sequence is identified (54) as not containing a valid code word. Then shifted code word boundaries are determined (55) for the section assuming at least one insertion or deletion error, and code words corresponding with the shifted boundaries are compared (56) with the code book to identify recovered valid code words.

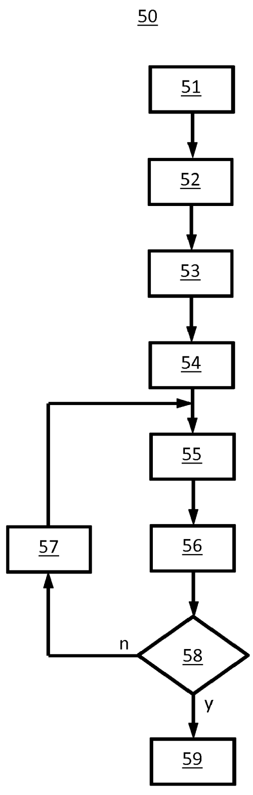


Fig. 5

EP 3 160 049 A1

## Description

## FIELD

The present disclosure is related to specific storage/transmission systems, where stored or transmitted sequences of code symbols are subject to insertion and/or deletion errors. More particularly, the present principles are related to the recovery of at least some valid code words from code word sequences corrupted by insertion or deletion errors which occur, for example, in the field of data storage in artificially created nucleic acid molecules.

## BACKGROUND

DNA (Deoxyribonucleic Acid) molecules, which are the biochemical storage molecules of genetic information, can be used to store arbitrary digital information, as nearly arbitrary strands or series of nucleotides can be generated with biochemical synthesizers. These synthesized series of nucleotides are also referred to as oligonucleotides or oligos. This usage of synthesized nucleic acid strands for storage of user data has been investigated in "Next-generation digital information storage", Church et al., Science 337, 1628, 2012 [I], and in "Towards practical, high-capacity, low-maintenance information storage in synthesized DNA", Goldman et al., Nature, vol. 494, 2013 [II]. Church stored about 650 kByte of data while Goldman showed that storing about 750 kByte of textual and media data in DNA was possible with biochemical machineries in 2012.

As schematically illustrated in Fig. 1, DNA molecules consist of two strands consisting of a series of four different molecules bonded together, similar to the structure of a common ladder. The schematically shown fragment of a DNA molecule 10 contains two strands 11, 12 which may be regarded as the ladder-bars while the different molecules bonded together may be regarded as the ladder-steps.

DNA strands are built from four different nucleotides identified by their respective nucleobases or nitrogenous bases, namely Adenine, Thymine, Cytosine and Guanine, which are denoted shortly as A, T, C and G, respectively, as indicated in Fig. 1. As another example, RNA (ribonucleic acid) strands also consist of four different nucleotides identified by their respective nucleobases, namely Adenine, Uracil, Cytosine and Guanine, which are denoted shortly as A, U, C and G, respectively.

Each of the DNA ladder-steps is formed by pairs of the four molecules while only two combinations of such base pairs occur. Guanine goes together with Cytosine (G-C), while Adenine connects with Thymine (A-T). In this context, A and T, as well as C and G, are called complementary. Guanine, Adenine, Thymine, and Cytosine are the nucleobases of the nucleotides, while their connections are addressed as base pairs. In Fig. 1, an example of a DNA molecule 10 is shown, which is a series of nucleotides bonded to the two strands 11, 12. Due to biochemical reasons, DNA strands have a predominant direction how they are read or biochemically interpreted. As shown in Fig. 1, this predominant direction is commonly indicated with '5' at the starting edge and '3' at the ending edge. Further, the predominant direction of strand 11 is indicated by arrow 13, whereas the predominant direction of strand 12 is indicated by arrow 14.

The predominant direction of DNA strands allows assigning logically to each base pair of an oligo a bit of information. In principle each nucleotide in an oligo strand can represent four numbers or code symbol values, as each single nucleotide of an oligo can be considered innately as a quaternary storage cell. For example, logical values can be assigned to the four nucleotides, identified by their nucleobases, as follows: 0 to G, 1 to A, 2 to T, and 3 to C. Since arbitrary series of nucleotides can be synthesized, any digital information can be stored in DNA strands. The data can be any kind of sequential digital data to be stored, e.g., sequences of quaternary code symbols, corresponding to digitally, for example binary, encoded information, such as textual, image, audio or video data. Due to the limited oligo length, the data is usually distributed to multiple oligos.

Synthesizers can produce oligos with a low error rate only of a certain length. For lengths that go beyond, the error rates increase significantly. For example, synthesizers may produce oligos having a length of up to 350 nucleotides. The possible oligo lengths depend on the working mechanism of the deployed synthesizer. As schematically illustrated in Fig. 2, data to be stored 21 consequently is cut into snippets or portions, while each snippet 22 is logically assigned to an oligo 23 of a predefined length, which carries the data contained in the snippet. Each oligo is identified by a unique identifier, index or address, respectively, so that the data snippets can be recombined in the right order when recovering the stored information.

The oligos can be stored, for example as solid matter or dissolved in a liquid, in a nucleic acid storage container, and the data can be recovered from the oligos by reading the sequence of nucleotides using a biological, biochemical and/or biophysical nucleic acid sequencer.

A nucleic acid sequencer is a device for determining the sequence of nucleotides within a nucleic acid molecule, such as a DNA molecule. A nucleic acid sequencer transforms the sequence of nucleotides into a corresponding sequence of code symbols.

However, the DNA synthesizing and sequencing machines can be prone to errors. The error rates of both the synthesizers as well as the sequencers can be very high. A large amount of the synthesizer failures are deletion and insertion errors. If a deletion error occurred, then the synthesizer had failed to add a nucleotide to the sequence as programmed, while an insertion error means that arbitrarily an additional nucleotide is included were it does not belong. Further, swap errors may occur. In these cases a wrong type of nucleotide had been included in the oligos. Sequencers on the other hand deliver data, i.e. transform the nucleotide sequences into corresponding code symbol sequences, at a certain error rate. They sometimes mistakenly output the representing data of a nucleotide that is not part of an oligo or they fail to detect a nucleotide. Regarding data recovery, both cases have the same effects as the deletion and insertion errors of the synthesizers.

When recovering user data stored in synthesized DNA molecules, deletion and insertion errors caused by the deployed synthesizers, the amplification processes, where oligos are duplicated many times, as well as the corresponding detection errors of the used sequencers have a serious impact on the data decoding, since a deletion as well as an insertion error shifts all nucleotides in a DNA molecule starting from the position where the error occurred. As the position in error is not known, insertion and deletion errors make it, without further encoding or processing means, impossible to decode all following nucleotides correctly, because it cannot be differentiated which nucleotide of an oligo has just been shifted or is in fact in error. Thus, the range of insertion and deletion errors can be huge.

In Fig. 3 and Fig. 4 shifting effects caused by deletion and insertion errors are illustrated. In Fig. 3 a portion of an error-free oligo or nucleotide sequence 31 is schematically illustrated. The arrow 32 indicates an erroneously inserted nucleotide "T", leading to a longer nucleotide sequence 33 than the original sequence 31. The arrow 34 indicates a position of an erroneously omitted nucleotide "C", leading to a shorter nucleotide sequence 35. In Fig. 4 an error-free sequencer output 41 of a code symbol sequence corresponding to the error-free oligo portion 31 shown in Fig. 3 is schematically illustrated, where quaternary code symbols corresponding to nucleotide types are represented according to a binary code table: A = 00, C = 01, T = 10, G = 11. The arrow 42 indicates the erroneously inserted "10" corresponding to the erroneously inserted "T" shown in Fig. 3, leading to a longer code symbol sequence 43. The arrow 44 indicates a position of an erroneously omitted "01", leading to a shorter code symbol sequence 45 corresponding to the shortened nucleotide sequence 35.

However, the shown sequences contain the code symbols grouped as consecutive code words, each consisting of a certain number of the code symbols, wherein only the code word that is actually subject to an insertion or deletion error is corrupted, whereas the subsequent code words are shifted. Without knowing the position in error, all subsequent code words are rejected as erroneous, resulting in a high overall error rate.

There remains a need to reduce the error rate of data provided in code word sequences being subject to insertion and/or deletion errors.

## SUMMARY

A data processing device and a method of operating the data processing device to recover valid code words from a code word sequence corrupted by insertion and/or deletion errors are presented.

According to one aspect of the present principles, a method of operating a data processing device to recover valid code words from a corrupted code word sequence, wherein the valid code words belong to at least one code book or code table of channel modulated code words of an identical length, comprises:

- obtaining a code word sequence;
- determining presumed code word boundaries for the code word sequence depending on said identical length;
- comparing code words corresponding with said presumed code word boundaries with the at least one code book to identify valid code words;
- identifying at least one section of the code word sequence as not containing a valid code word;
- determining shifted code word boundaries for the at least one section under an assumption of at least one insertion or deletion error; and
- comparing code words corresponding with said shifted code word boundaries with the at least one code book to identify recovered valid code words.

A code word sequence consists of a set of code words, each consisting of a sequence of a number of code symbols. A correct code word consists of a number of code symbols corresponding to the identical length. A corrupted code word sequence comprises at least one code word having a length different from the identical length, due to insertion or deletion error.

The code word sequence is obtained from a data transmission medium or data channel, such as a data storage or data communication channel, including means for storing/sending, i.e. writing, the data, and retrieving/receiving, i.e. reading, the data, wherein the channel can be error-prone. For example, a nucleic acid data storage channel, such as a DNA data storage channel, may comprise a nucleic acid synthesizer, a nucleic acid storage container for storing at least the synthesized oligos, e.g. synthesized DNA, and a nucleic acid sequencer configured to sequence and retrieve the sequences of nucleotides of the stored oligos, e.g. synthesized DNA.

The code word sequence is obtained from the data channel, e.g., as an electronic signal obtained from a data storage channel connected to a data processing device via an interface. For example, when processing data stored in nucleotide sequences, the code word sequence may correspond to a transformed version of the sequence of nucleotides stored in an oligo.

The at least one code book of channel modulated code words is provided to the data processing device e.g. from a memory having stored therein the code book or code table.

The initially found correct and recovered valid code words are then provided to an output, further processed and decoded or stored in a memory for later processing.

Accordingly, a data processing device for recovering valid code words from a corrupted code word sequence, wherein the valid code words belong to at least one code book of channel modulated code words of an identical length, comprises a processor and a memory storing instructions that, when executed, cause the processor to:

- obtain a code word sequence;
- determine presumed code word boundaries for the code word sequence depending on said identical length;
- compare code words corresponding with said presumed code word boundaries with the at least one code book to identify valid code words;
- identify at least one section of the code word sequence as not containing a valid code word;
- determine shifted code word boundaries for the at least one section under an assumption of at least one insertion or deletion error; and
- compare code words corresponding with said shifted code word boundaries with the at least one code book to identify recovered valid code words.

According to one aspect of the present principles, a computer program comprises code instructions executable by a processor for implementing a method according to the present principles.

Accordingly, a non-transitory program storage device, readable by a computer, tangibly embodies a program of instructions executable by the computer to perform a method for recovering valid code words from a corrupted code word sequence, wherein the valid code words belong to at least one code book of channel modulated code words of an identical length, comprising:

- obtaining a code word sequence;
- determining presumed code word boundaries for the code word sequence depending on said identical length;
- comparing code words corresponding with said presumed code word boundaries with the at least one code book to identify valid code words;
- identifying at least one section of the code word sequence as not containing a valid code word;
- determining shifted code word boundaries for the at least one section under an assumption of at least one insertion or deletion error; and
- comparing code words corresponding with said shifted code word boundaries with the at least one code book to identify recovered valid code words.

The term "to recover valid code words from a corrupted code word sequence" refers to identifying positions of valid code words within a code word sequence that contains at least one insertion or deletion error and making the code words accessible for readout. In an embodiment a corrupted code word sequence corresponds to a code word sequence retrieved from sequencing a corrupted oligo containing at least one nucleotide insertion or deletion error.

A "code book of channel modulated code words " refers to a code look-up table or output of any code generating means, adapted to provide a mapping of input user data to valid code words, i.e. valid output code words, adapted to at least some characteristics of the storage or transmission medium or channel. Thereby, the code book allows to apply a channel modulation of the data. For example, in an embodiment nucleic acid storage channel modulated code words are generated taking into account self-reverse complementarity and run length restrictions of a number of identical nucleotides in artificially generated oligos caused by the biochemical processing. A code book may, for example, provide a mapping of binary input code words to quaternary valid output code words, e.g. corresponding to the four nucleotide types used in an oligo.

Due to the channel modulation the valid code words contained in the at least one code book are a subset containing less than all possible code words. The code words not contained in the at least one code book are considered invalid code words. In an embodiment the number of invalid code words is greater than the number of valid code words, thereby reducing a probability that a shifting of valid code words results in a shifted section comprising one or more valid code words different from the originally encoded valid code words.

Code words of an identical length consist of an identical number of code symbols.

The valid code words recovered from the corrupted code word sequence belong to the at least one code book, i.e. the recovered valid code words match with entries of the at least one code book which contains valid code words.

A "code word boundary" identifies a position within the code word sequence where a code word begins or ends. The determination of "presumed code word boundaries of the code word sequence depending on the identical length" is carried out, for example, under an assumption that the code word sequence has been generated as a concatenation of valid code words, each of an equal or identical length. In this example, after each multiple of the identical length times the number of code symbols a valid code word consists of, a code word boundary is presumed.

"Comparing code words corresponding with the presumed code word boundaries with the at least one code book to identify valid code words" refers to identifying valid code words within the code word sequence by comparing sections of the code word sequence, being in line with the presumed code word boundaries, with entries contained in the code book and considering a found match as a valid code word contained in the code word sequence.

The determination of shifted code word boundaries for the at least one section under an assumption of at least one insertion or deletion error refers to a calculation of a possible shift, e.g. as a difference, between the originally generated code word sequence and the obtained code word sequence or between the at least one section not containing a valid code word and a corresponding section within the originally generated code word sequence.

If a dedicated suited code book or code table is used when encoding the data to be stored then in many cases the shifting effects of deletion and insertion errors can be narrowed down to the length of just one code word. The decoding process then comprises 'trial and error' modules searching for valid code words or code word boundaries shifted due to assumed particular insertion or deletion errors, respectively, thus correcting insertion and deletion errors.

The solution according to aspects of the present principles allows identification of a corrupted section of a code word sequence, e.g. retrieved by sequencing a data carrying oligo. The corrupted section does not contain valid code words aligned with assumed code word boundaries. The assumed boundaries for the section are modified assuming that the section contains at least one correct code word that has been shifted due to one or more insertion or deletion errors, and the section is searched for correct code words according to said now shifted code word boundaries. These selective trial and error searches deliver "soft decisions" with a certain probability of correctness.

The provided solution at least has the effect that an impact of insertion and deletion errors can be reduced to the actually corrupted code word in the code word sequence in a computationally efficient way. This reduces the error rate very much, in particular for data retrieval from transmission or storage channels where insertion and/or deletion errors frequently occur, such as retrieval of data stored in synthesized nucleic acid molecules, e.g. artificially created DNA oligos. Thereby, the sequencing of the oligos and information retrieval will be faster, since corrupted code word sequences can at least partly be used to derive correct information from.

In one embodiment the determining of shifted code word boundaries and the comparing of code words corresponding with said shifted code word boundaries are repeated with differently shifted code word boundaries if no recovered valid code words were identified. This allows modifying the trial and error search within the corrupted section of the code word sequence, if the previously assumed or tested shift has been found wrong. The assumed shift depends on an assumed amount or number of insertion or deletion errors. This amount can be derived from a known length of, i.e. a number of code symbols contained in, a valid code word and a difference between a length of the obtained code word sequence and a predetermined length of an error-free code word sequence which may be invariant or received as a parameter.

In one embodiment the shifted code word boundaries for the at least one section are determined under an assumption of at least one insertion error if a length of the obtained code word sequence, i.e. a number of code symbols contained in the code word sequence, exceeds a predetermined length of an error-free code word sequence, i.e. an expected number of code symbols of the code word sequence. For example, shifted code word boundaries corresponding to an insertion of a number of code symbols equal to the difference between the obtained length and the predetermined length will be tested first.

In one other embodiment the shifted code word boundaries for the at least one section are determined under an assumption of at least one deletion error if a predetermined length of an error-free code word sequence exceeds a length of the obtained code word sequence. For example, shifted code word boundaries corresponding to a deletion of a number of code symbols equal to the difference between the predetermined length and the obtained length will be tested first.

In one embodiment the comparing of code words corresponding with said shifted code word boundaries comprises for code words corresponding with the shifted code word boundaries but not having said identical length, generating modified versions of said code words, having the identical length, and comparing the modified versions with the at least one code book. The modified versions are generated by either inserting or deleting one or more code symbols of the code word at different positions of said code word to correct the code word length. Although many such modified code words will be found invalid when comparing with the code book, there remains a probability that more than one modified code word is regarded a valid code word according to the code book. This potential ambiguity can be resolved, for example if error detection or correction data is available for the code words.

In one embodiment the comparing of code words corresponding with said shifted code word boundaries comprises at least one of verifying said code words using additionally provided error detection data and correcting said code words using additionally provided error correction data. This error detection data or error correction data can be provided encoded in the code words and allows, for example, removal or correction of modified code words containing errors. However, any code word, for example any code word derived from shifting code word boundaries, can be checked in case of available error detection or correction data.

In one embodiment the obtaining of the code word sequence comprises sequencing an oligo carrying the code word sequence encoded by a sequence of nucleotides forming the oligo. For this, the data processing device is connectable to a nucleic acid storage container and comprises a nucleic acid sequencer device configured to sequence nucleic acid molecules stored in said nucleic acid storage container. In another embodiment the data processing device is connected to the nucleic acid sequencer device instead of comprising it.

In one embodiment the channel modulated code words are code words modulated to adapt to a nucleic acid storage channel. Biological, biochemical and biophysical processes, such as synthesizers, amplifiers and sequencers do not always work correctly. The nucleic acid storage channel comprises the nucleic acid synthesizer, the storage, an amplifier which creates multiple copies of the same oligos, and a nucleic acid sequencer. For channel modulation of the code words in order to adapt to the constraints of said channel, to improve reliability of the processes when storing arbitrary data in nucleic acid molecules or oligos, the valid code words of the code book are designed or selected in view of the channel constraints.

For example the following constraints may be considered: According to a run-length constraint, the data representing oligos should avoid to contain sections of nucleotides of the same kind that exceed a certain length n, as cascades or sequences of identical nucleotides may reduce sequencing accuracy if the run length exceeds n. Such an oligo section is called homopolymer run-length n. According to the constraint of self-reverse complementarity, the data representing oligos should not have sections of self-reverse complementary sequences of nucleotides that exceed a certain length.

Long self-reverse complementary sequences may not be readily sequenced, which hinders correct decoding of the information encoded in the oligo. Two sequences of nucleotides are considered "reverse complementary" to each other, if an antiparallel alignment of the nucleotide sequences results in the nucleobases at each position being complementary to their counterparts. Reverse complementarity does not only occur between separate strands of DNA or RNA. It is also possible for a sequence of nucleotides to have internal, self-reverse complementarity.

In one embodiment the obtained code word sequence consists of quaternary code symbols. This corresponds to obtaining the code word sequence by transforming a sequence of nucleotides into a corresponding sequence of code symbols. A nucleotide, which is the smallest data information carrying unit to store data in DNA, can be one out of four molecules (A, C, T, G). Therefore, a nucleotide can represent 2 bits of data.

In one embodiment said identical length of the valid code words equals five code symbols. The channel modulation has to be adapted to the characteristics of the data channel as exactly as possible. For example, for data storage in DNA oligos, in an embodiment the channel modulation ensures that not more than 5 identical nucleotides $n \in \{A, C, G, T\}$ are stored in a row. In order to unambiguously code all values a data byte can take, at least $2^8 = 256$ code words are needed. A nucleotide can be one out of four molecules (A, C, T, G). A data byte can be assigned to 4 nucleotides ($4^4 = 256$). However, in this case there is no degree of freedom left so that a series of code words can be adapted to meet constraints of the data channel, e.g. for a nucleic acid storage channel for example the nucleotide run-length and self-reverse complementary constraints. Consequently, according to the embodiment a data byte is mapped to 5 or more nucleotides, leading to 256 valid and 768 invalid code words for the case of 5 nucleotides.

In one embodiment the user data represented by the code word sequence is provided with an error detection encoding. As the decisions whether or not a valid code word has been recovered after shifting the code word boundaries are soft decisions, since with a certain probability a shifted code symbol sequence may result in a valid code word but not the original one, the content of the recovered code word can be verified using the encoded additional error detection and/or correction data, e.g. a checksum such as a cyclic redundancy check, or hash values, as well as cyclic error detection and correction data.

In one embodiment the valid code words belong to a plurality of code books or code tables of channel modulated code words wherein none of the valid code word belongs to more than one code book, and wherein the obtained code word sequence comprises code words belonging to at least two of said code books. Insertion and deletion errors can also be narrowed down, if at least two code books or code tables being exclusive to each other are used, and the code books are used alternatingly, i.e. the code word sequences are generated by alternatingly selecting code words from the different codes, when encoding the data.

A data processing device is or comprises, for example, a processor, microprocessor, microcontroller, computer or other programmable apparatus or processor assembly capable of processing the data. Further, in an embodiment of the data processing device, the device comprises a memory having stored therein the at least one code book. In another embodiment the memory is connected or connectable to the data processing device via an interface.

In one embodiment the data processing device comprises a nucleic acid sequencer or is connected or connectable to it via an interface. In one embodiment the data processing device is part of a nucleic acid storage system for storing user data in and retrieving the stored information from synthesized nucleic acid sequences in a nucleic acid storage container.

The present principles may be part of a preprocessing for user data decoding in a decoder, wherein only obtained code word sequences having a length differing from an expected or known length are processed according to the present principles, as insertion or deletion errors can be assumed. In one embodiment the retrieved detected and recovered valid code words are then provided to a user data decoder device for further processing and decoding of the user data. In another embodiment the retrieved valid code words are stored in a memory for later processing.

While not explicitly described, the presented embodiments may be employed in any combination or sub-combination.

BRIEF DESCRIPTION OF THE DRAWINGS

Fig. 1 schematically illustrates a structure of a fragment of a DNA molecule;

Fig. 2 schematically illustrates a principle of data assignment to oligos to be used for DNA data storage;

Fig. 3 schematically illustrates an initially error-free nucleotide sequence being subject to shifting effects caused by deletion and insertion errors;

Fig. 4 schematically illustrates a sequencer output of code symbol sequences corresponding to the nucleotide sequence shown in Fig. 3;

Fig. 5 schematically illustrates an embodiment of a method of operating a data processing device to recover valid code words from a corrupted code word sequence;

Fig. 6 schematically illustrates an example of an initially error-free code word sequence corresponding to a nucleotide sequence being subject to an insertion error;

Fig. 7 schematically illustrates another example of an initially error-free code word sequence corresponding to a nucleotide sequence being subject to an insertion error;

Fig. 8 schematically illustrates an embodiment of a data processing device for recovering valid code words from a corrupted code word sequence; and

Fig. 9 schematically illustrates an embodiment of an apparatus for decoding code word sequences received from a data storage or transmission medium. Identical reference numerals refer to identical or similar items.

**DETAILED DESCRIPTION OF EMBODIMENTS**

For a better understanding of the principles, example embodiments are explained in more detail in the following description with reference to the figures. It is understood that the present solution is not limited to these exemplary embodiments and that specified features can also expediently be combined and/or modified without departing from the scope of the present principles as defined in the appended claims.

Referring to Fig. 5, an embodiment of a method 50 of operating a data processing device to recover valid code words from a corrupted code word sequence, wherein the valid code words belong to at least one code book or code table of channel modulated code words of an identical length, is schematically illustrated. The method may, for example, be computer implemented. The code word sequence is identified as corrupted, if its length, i.e. number of contained code symbols, is not a multiple of the identical length, which is the length, i.e. the number of code symbols, each code word consists of. The identical length is a constant or variable value known or received from a memory or the data channel.

In the shown embodiment, in a first step 51 a code word sequence is obtained, e.g. as an electronic signal obtained from a data storage channel connected to a data processing device via an interface. For example, when processing data stored in nucleotide sequences, the code word sequence may correspond to a transformed version of the sequence of nucleotides stored in an oligo.

In a second step 52 presumed code word boundaries for the code word sequence depending on said identical length are determined, i.e. calculated. For example, presumed code word boundaries are calculated as multiples of said identical length of the code words.

In a third step 53 code words corresponding with the presumed code word boundaries are compared with the at least one code book or code table to identify valid code words. In other words, the code words corresponding with the presumed code word boundaries are compared with the valid code words of the code book and identified as valid, if a matching valid code word is contained in the code book.

In a fourth step 54 at least one section of the code word sequence is identified as not containing a valid code word. A section is identified as not containing a valid code word, if no match between any of the entries of the at least one code book and the section has been found. As the code word sequence being processed is a corrupted code word sequence where the length does not represent a multiple of said identical length, at least one such section must be contained in the code word sequence.

In a fifth step 55 shifted code word boundaries are determined for the at least one section under an assumption of at least one insertion or deletion error. The code word boundaries for the section are re-calculated, for example, shifted by +1 or -1 compared to the corresponding previously presumed code word boundaries.

In a sixth step 56 code words corresponding with the shifted code word boundaries are compared with the at least one code book to test whether recovered valid code words can now be identified.

In an embodiment this comparison 56 is performed only for those code words corresponding with said shifted code word boundaries and having the correct length i.e. said identical length, that matches with the length of the valid code words provided in the code book. In another embodiment this comparison 56 is also performed for code words corresponding with the shifted code word boundaries but not having said identical length. In the latter case, the comparison comprises generating modified versions of said code words, having the identical length, and comparing the modified versions with the at least one code book. The modified versions are generated by either inserting or deleting one or more code symbols of the code word at different positions of said code word to correct the code word length. Although many such modified code words will be found invalid when comparing with the code book, there remains a probability that more than one modified code word is regarded a valid code word according to the code book. This potential ambiguity can be resolved, for example if error detection or correction data is available for the code words by verifying said code words using additionally provided error detection data and correcting said code words using additionally provided error correction data.

In the shown embodiment the assumption is modified 57 and the determining 55 of shifted code word boundaries and the comparing 56 of code words corresponding with the shifted code word boundaries are repeated with differently shifted code word boundaries, if no recovered valid code words were identified 58.

Otherwise, the processing ends 59. Please note that this may only refer to the currently processed corrupted code word sequence. The overall processing continues, e.g. with a next corrupted code word sequence and/or with processing or decoding of the information encoded in the identified valid code words.

In the following, the present principles are further described with respect to an example nucleic acid storage channel modulation.

Generally, one goal is to store data effectively, which often means storing data reliable with a high density. Consequently, the channel modulation is adapted to the data channel as exactly as possible. As an example, due to biochemical reasons implied by a nucleic acid storage system, in an embodiment the channel modulation ensures that not more than 5 equal or identical nucleotides $n \in \{A, C, G, T\}$ are stored in a row. In order to unambiguously code all values a data byte can take on, at least $2^8 = 256$ code words are needed.

A nucleotide, which is the smallest data information carrying unit to store data in DNA, can be one out of four molecules (A, C, T, G). Therefore, a nucleotide can represent 2 bits of data. Consequently, a data byte could be assigned to 4 nucleotides. Here, in order to have a degree of freedom left so that a series of code words can meet constraints of the data channel, a data byte is assigned to more than 4 nucleotides.

Consequently, without loss of generality, according to the described example embodiment, it is assumed that user data is stored byte wise and each data byte b of user data is mapped to or transformed into a code word or tuple of 5 quaternary code symbols that is transformed into 5 corresponding nucleotides using a nucleic acid synthesizer. For the described example, it is further assumed that code word sequences of 120 code symbols are synthesized as oligos, in other words that synthesized oligos are 120 nucleotides long (besides probably another known number of additionally required nucleotides, e.g. as primers). A mapping of sequences of user data, e.g. binary encoded user data, to the valid code words or $Nt_5$ tuples is available through a code book which is provided as a code look-up table or generated by a code generator means.

The data to be stored are represented by accordingly concatenated $Nt_5$ tuple code words of the code book or code table. According to the example, in order to form a code word sequence for synthesizing one oligo regularly $\frac{120}{5} = 24\ Nt_5$ tuples are concatenated.

Table 1 abstractly shows the data byte assignment to code words or tuples of 5 code symbols ($Nt_5$) corresponding to 5 nucleotides:

(Table 1)

| |
|---|
| *byte b* = $\{b_0, b_1, b_2, b_3, b_4, b_5, b_6, b_7\}$, *while* $b_i \in \{0,1\}$, $0 \le i \le 7$ |
| $Nt_5 = \{n_0, n_1, n_2, n_3, n_4\}$, *while* $n_j \in \{A, C, G, T\}$, $0 \le j \le 4$ |
| $byte\ b \xrightarrow{mapping} Nt_5$ |

With these $Nt_5$ tuples an oligo with N nucleotides can be defined, created by transforming the N concatenated $Nt_5$ tuples into a corresponding sequence of nucleotides: *oligo 0* $\hat{=}$ ($Nt_{5,0}$, $Nt_{5,1}$, $Nt_{5,2}$, ... , $Nt_{5,j}$, ..., $Nt_{5,N-1}$), $0 \le J \le N - 1$

In principle, the $Nt_5$ tuples span in total a space of $4^5 = 1024$ code words, which may belong to one single code book or code table. In order to unambiguously code all values a data byte can take on, at least $2^8 = 256$ code words are needed. Code words that obey the storage channel constraints are the so called valid code words, according to which all other code words are invalid code words. In other words, the complete set of valid $Nt_5$ code words is only a subset of all possible code words that could be defined.

Table 2 abstractly shows a code book or code table $n_{CT}$ containing $Nt_5$ code words:

(Table 2)

| |
|---|
| $byte\ b = \{b_0, b_1, b_2, b_3, b_4, b_5, b_6, b_7\} \xrightarrow{mapping} \{n_0, n_1, n_2, n_3, n_4\} = n_{CT}, while$ |
| $bit\ b_i \in \{0,1\}, 0 \le i \le 7$ |
| *code symbol corresponding to nucleotide:* $n_j \in \{A, C, G, T\}$, $0 \le j \le 4$ *code table* $n_{CT}$ |

Because there are more invalid than valid code words, insertion and deletion errors result more often in invalid code words. In the described example embodiment using $Nt_5$ code words, there are three times more invalid than valid code words. Insertion as well as deletion errors cause the nucleotides to be virtually shifted. If there are more insertion errors than deletion errors, then the oligos are prolonged, while they vice versa are shortened. Due to the fact that there are more invalid than valid code words the oligo positions were the insertion and deletion errors occurred can be narrowed down. At an oligo position where a deletion or insertion error happens by chance, with a certain degree of probability only invalid $Nt_5$ code words are found. The shifted remaining code words are found by comparing the valid code words of the code book with the tuples of 5 nucleotides.

As an example, Fig. 6 schematically illustrates an initially error-free code word sequence 61 consisting of N consecutive $Nt_5$ tuples or code words and corresponding to a nucleotide sequence. In the shown example, the nucleotide sequence and, therefore, the corresponding code word sequence is subject to an insertion error 62 that changes the error-free code word sequence 61 into a corrupted code word sequence 63. As shown in Fig. 6, the erroneous section can be narrowed down to the length of just one code word 64, as on the one hand remaining correct code words $Nt_{5,0}$ and $Nt_{5,1}$ can be detected corresponding to unchanged code word boundaries 65 and on the other hand recovered correct code words $Nt_{5,3}$ ... $Nt_{5,N-1}$ can be detected corresponding to shifted code word boundaries 66, as the insertion error results in shifted nucleotides and, thereby, shifted code words. Hence, not a complete oligo is lost when recovering the stored data, but only a small portion of it. In many cases the code word sequence obtained from the defect oligo can to a certain degree of probability be corrected by exploiting additional error detection and/or correction data.

As another example, Fig. 7 schematically illustrates another initially error-free code word sequence 71 corresponding to a nucleotide sequence being subject to an insertion error. In case of a DNA sequence, the shown code word sequence corresponds to one strand of the generated oligo. Here, the $Nt_5$ code words are shown by their quaternary code symbols corresponding to the nucleotides A, T, C and G. The code word sequence has been generated by alternately concatenating code words belonging to different code books or code tables. The first code word 72 belongs to a first code book or code table I, the second code word 73 belongs to a second code table II, and the third shown code word 74 belongs to a third code table III. Code symbols of a next code word 75 will then again belong to the first code table. Here, insertion and deletion errors can also be narrowed down, as more than one code table is used. Again, in many cases the code word sequence obtained from the defect oligo can to a certain degree of probability be corrected by exploiting additional error detection and/or correction data.

According to the shown example, indicated by different background hatchings, three code tables I, II and III are used alternatingly when encoding the data. This also allows to narrow down the shifting effects of deletion and insertion errors, because all code words belong uniquely only to one code table. The used code books or code tables are exclusive to each other, i.e. they share no common code word. Table 3 below abstractly shows a set of three exclusive code tables:

(Table 3)

| | | |
|---|---|---|
| Code Table I | $byte\ b = \{b_0, b_1, b_2, b_3, b_4, b_5, b_6, b_7\} \xrightarrow{mapping} \{n_{1,0}, n_{1,1}, n_{1,2}, n_{1,3}, n_{1,4}\} = n_1, while$<br>$bit\ b_i \in \{0,1\}, 0 \leq i \leq 7$<br>*code symbol corresponding to nucleotide:* $n_{1,j} \in \{A, C, G, T\}, 0 \leq j \leq 4$ | |
| Code Table II | $byte\ b = \{b_0, b_1, b_2, b_3, b_4, b_5, b_6, b_7\} \xrightarrow{mapping} \{n_{2,0}, n_{2,1}, n_{2,2}, n_{2,3,}, n_{2,4}\} = n_2, while$<br>$bit\ b_i = \{0,1\}, 0 \leq i \leq 7$<br>*code symbol corresponding to nucleotide:* $n_{2,j} = \{A, C, G, T\}, 0 \leq j \leq 4$ | |
| Code Table III | $byte\ b = \{b_0, b_1, b_2, b_3, b_4, b_5, b_6, b_7\} \xrightarrow{mapping} \{n_{3,0}, n_{3,1}, n_{3,2}, n_{3,3,}, n_{3,4}\} = n_3, while$<br>$bit\ b_i = \{0,1\}, 0 \leq i \leq 7$<br>*code symbol corresponding to nucleotide:* $n_{2,j} = \{A, C, G, T\}, 0 \leq j \leq 4$ | |
| Independence of Code Table I, II, and III: | | $n_1 \neq n_2 \neq n_3\ \forall$ 256 *tuples*<br>$n_1 \in$ *Code Table I* |
| | | $n_2 \in$ *Code Table II*<br>$n_3 \in$ *Code Table III*<br>(at least one code symbol/nucleotide of the tuples differ) |

In an embodiment, code words of the code tables I, II and III can be concatenated strictly alternatingly. Then a code word sequence corresponding to an oligo is formed like according to the following scheme: ($C_1$, $C_2$, $C_3$, ..., $C_1$, $C_2$, $C_3$), *while* $C_i \in T_i$, $i \leq 1 \leq 2$, with $C_i$ being a code word of Table $T_i$.

In another embodiment, where restrictions prevent regular application of the code tables strictly alternatingly, a deviation from the alteration of the code books or code tables, e.g. for one or two code words, can be introduced. This may be the case, if for example, due to biological, biochemical, and biophysical reasons, oligos shall not show self-reverse complementary sections. As an example, code words of the three code tables could then be concatenated accordingly to the following scheme:

$$(C_1, C_2, C_3, \cdots, C_1, C_1, C_3, \cdots, C_2, C_2, C_3, \cdots), while\ C_i \in T_i, 1 \leq i \leq 2.$$

The effects of deletion and insertion errors are, thereby, limited. The code words of code tables have to be searched to detect the code word boundaries of the code words in the corrupted code word sequence.

Still referring to Fig. 7, the code word sequence 76 corresponds to the code word sequence 71, being subject to an insertion error 77 that shifts all subsequent code symbols in the code word sequence (corresponding to nucleotides in an oligo) one position to the right. Therefore, after detecting the last code word 72 before the error 77 occurred, no valid code word can be found when comparing with any of the code tables.

During the next processing step code words are searched under the assumption that an insertion error has occurred, shifting the nucleotides, respectively code symbols after readout of the code word sequence, after the insertion error occurred, to the right. In the shown example the next code word that is found is a code word 78 belonging to the third code table, leaving only section 79 remaining as containing a corrupted code word. Next, it can be checked, for example by trial and error tests or by exploiting additional error detection and/or correction data, if available, at which position a nucleotide has been mistakenly inserted. As indicated in Fig. 7, the second position in the effected code word belonging to the second code table is identified to be wrong, as it contains insertion error 77. In this way the insertion error can be corrected.

According to further aspects of the present principles, an example of an embodiment of a data processing device for recovering valid code words from a corrupted code word sequence is schematically shown in Fig. 8. The data processing device 80 allows implementing the advantages and characteristics of the described method as part of a data processing device for recovering valid code words from a corrupted code word sequence.

The data processing device 80 for recovering valid code words from a corrupted code word sequence is shown in Fig. 8. The valid code words belong to at least one code book or code table of channel modulated code words of an identical length. The at least one code book or code table can be generated by a processor 81 comprised in the data processing device 80 or be obtained from a memory module, e.g. memory 82, connected or connectable to the processor 81 and having stored therein the at least one code book. In the shown embodiment, the memory 82 is connected to the processor 81.

The term "processor" refers to at least one processor, microprocessor, microcontroller or other processing device, processor assembly, computer or other programmable apparatus. As an example, the processor 81 can be a processor adapted to perform the steps according to one of the described methods. In one embodiment according to the present principles, said adaptation comprises that the processor is configured, e.g. programmed, to perform steps according to one of the described methods of operating the data processing device to recover valid code words from a corrupted code word sequence.

A part of the shown memory 82 can be a non-transitory program storage device readable by the processor 81, tangibly embodying a program of instructions executable by the processor 81 to perform program steps as described herein according to the present principles.

The data processing device 80 comprises the processor 81 and memory 82 storing instructions that, when executed, cause the processor 81 to:

- obtain a code word sequence;
- determine presumed code word boundaries for the code word sequence depending on said identical length;
- compare code words corresponding with said presumed code word boundaries with the at least one code book to identify valid code words;
- identify at least one section of the code word sequence as not containing a valid code word;
- determine shifted code word boundaries for the at least one section under an assumption of at least one insertion or deletion error; and
- compare code words corresponding with said shifted code word boundaries with the at least one code book to identify recovered valid code words.

The data processing device is connected or connectable to a data channel, i.e. a data transmission medium or channel, such as a data storage or data communication channel, for receiving or obtaining code word sequences, for example in the form of electric or electronic signals, to process corrupted code word sequences. In the shown embodiment the data processing device 81 is connected to a data storage channel comprising a nucleic acid sequencer 83 configured to sequence nucleic acid sequences such as artificially created DNA oligos having encoded user data by transforming the nucleic acid sequences into corresponding code word sequences, wherein the nucleic acid sequencer 83 is connected to a nucleic acid storage container 84 containing at least the nucleic acid sequences, for example provided as solid matter or in a liquid solution. In one other embodiment the data processing device 81 may comprise the nucleic acid sequencer 83 instead of being connected to it.

Referring to Fig. 9, an embodiment of an apparatus 90 for decoding code word sequences received from a data storage or transmission medium is schematically shown. The apparatus 90 comprises a data processing device 80 which corresponds to the data processing device 80 shown in Fig. 8, for recovering valid code words from a corrupted code word sequence according to the present principles. The apparatus 90 further comprises a decoding device 91 configured to decode at least the recovered valid code words provided by the data processing device 90. In another embodiment the decoding device 90 comprises the data processing device 80 or vice versa.

Aspects of the present principles can be embodied as a method, an apparatus, a system, a computer program product or a computer readable medium, i.e. the present principles may be implemented in various forms of hardware, software, firmware, special purpose processors, or a combination thereof. Accordingly, aspects of the present principles can take the form of a hardware embodiment, a software embodiment or an embodiment combining software and hardware aspects. Aspects of the present principles may, for example, at least partly be implemented in a computer program comprising code portions for performing steps of the method according to an embodiment of the present principles when run on a programmable apparatus or enabling a programmable apparatus to perform functions of an apparatus, device or system according to an embodiment of the present principles. Moreover, the software is preferably implemented as an application program tangibly embodied on a program storage device. The application program may be uploaded to, and executed by, a machine comprising any suitable architecture. Preferably, the machine is implemented on a computer platform having hardware such as one or more processors/central processing units (CPU), a random access memory (RAM), and input/output (I/O) interface(s). The computer platform also includes an operating system and microinstruction code. The various processes and functions described herein may either be part of the microinstruction code or part of the application program (or a combination thereof), which is executed via the operating system. In addition, various other peripheral devices may be connected to the computer platform such as an additional data storage device and a printing device, as well as a nucleic acid sequencer device. Unless stated otherwise, terms such as "first" and "second" are used to arbitrarily distinguish between the elements the terms describe and are not necessarily intended to indicate temporal or other prioritization of the elements. Any connection shown may be a direct connection or an indirect connection.

Further, those skilled in the art will recognize that the boundaries between logic blocks are merely illustrative and that alternative embodiments may merge logic blocks or impose an alternate decomposition of functionality upon various logic blocks.

**CITATION LIST**

[I] George M. Church, Yuan Gao, Sriram Kosuri, "Next-Generation Digital Information Storage in DNA", Science Vol. 337, 28 September 2012.

[II] Nick Goldman et al., "Towards practical, high-capacity, low-maintenance information storage in synthesized DNA", Nature Vol. 494, January 2013.

## Claims

1. A method (50) of operating a data processing device to recover valid code words from a corrupted code word sequence, the valid code words belonging to at least one code book of channel modulated code words of an identical length, the method comprising:

   - obtaining (51) a code word sequence;
   - determining (52) presumed code word boundaries for the code word sequence depending on said identical length;
   - comparing (53) code words corresponding with said presumed code word boundaries with the at least one code book to identify valid code words;
   - identifying (54) at least one section of the code word sequence as not containing a valid code word;
   - determining (55) shifted code word boundaries for the at least one section under an assumption of at least one insertion or deletion error; and
   - comparing (56) code words corresponding with said shifted code word boundaries with the at least one code book to identify recovered valid code words.

2. The method according to claim 1, wherein the determining (55) of shifted code word boundaries and the comparing (56) of code words corresponding with said shifted code word boundaries are repeated with differently shifted code word boundaries if no recovered valid code words were identified.

3. The method according to claim 1 or claim 2, wherein the shifted code word boundaries for the at least one section are determined under an assumption of at least one insertion error if a length of the obtained code word sequence exceeds a predetermined length of an error-free code word sequence.

4. The method according to claim 1 or claim 2, wherein the shifted code word boundaries for the at least one section are determined under an assumption of at least one deletion error if a predetermined length of an error-free code word sequence exceeds a length of the obtained code word sequence.

5. The method according to any of the preceding claims, wherein for code words corresponding with the shifted code word boundaries but not having said identical length, the comparing (56) of code words corresponding with said shifted code word boundaries comprises generating modified versions of said code words having the identical length and comparing the modified versions with the at least one code book.

6. The method according to any of the preceding claims, wherein the comparing (56) of code words corresponding with said shifted code word boundaries comprises at least one of verifying said code words using additionally provided error detection data and correcting said code words using additionally provided error correction data.

7. The method according to any of the preceding claims, wherein the obtaining (51) of the code word sequence comprises sequencing an oligo carrying the code word sequence encoded by a sequence of nucleotides forming the oligo.

**8.** The method according to any of the preceding claims, wherein the channel modulated code words are code words modulated to adapt to a nucleic acid storage channel.

**9.** The method as claimed in any of the preceding claims, wherein the obtained code word sequence consists of quaternary code symbols.

**10.** The method according to any of the preceding claims, wherein said identical length of the valid code words equals five code symbols.

**11.** The method according to any of the preceding claims, wherein the user data represented by the code word sequence is provided with an error detection encoding.

**12.** The method according to any of the preceding claims, wherein the valid code words belong to a plurality of code books of channel modulated code words wherein none of the valid code word belongs to more than one code book, and wherein the obtained code word sequence comprises code words belonging to at least two of said code books.

**13.** A data processing device (80) for recovering valid code words from a corrupted code word sequence, the valid code words belonging to at least one code book of channel modulated code words of an identical length, the data processing device comprising a processor (81) and a memory (82) storing instructions that, when executed, cause the processor to:

- obtain a code word sequence;
- determine presumed code word boundaries for the code word sequence depending on said identical length;
- compare code words corresponding with said presumed code word boundaries with the at least one code book to identify valid code words;
- identify at least one section of the code word sequence as not containing a valid code word;
- determine shifted code word boundaries for the at least one section under an assumption of at least one insertion or deletion error; and
- compare code words corresponding with said shifted code word boundaries with the at least one code book to identify recovered valid code words.

**14.** A computer program, comprising code instructions executable by a processor for implementing a method according to at least one of claims 1 to 12.

**15.** A non-transitory program storage device, readable by a computer, tangibly embodying a program of instructions executable by the computer to perform a method for recovering valid code words from a corrupted code word sequence, the valid code words belonging to at least one code book of channel modulated code words of an identical length comprising:

- obtaining (51) a code word sequence;
- determining (52) presumed code word boundaries for the code word sequence depending on said identical length;
- comparing (53) code words corresponding with said presumed code word boundaries with the at least one code book to identify valid code words;
- identifying (54) at least one section of the code word sequence as not containing a valid code word;
- determining (55) shifted code word boundaries for the at least one section under an assumption of at least one insertion or deletion error; and
- comparing (56) code words corresponding with said shifted code word boundaries with the at least one code book to identify recovered valid code words.

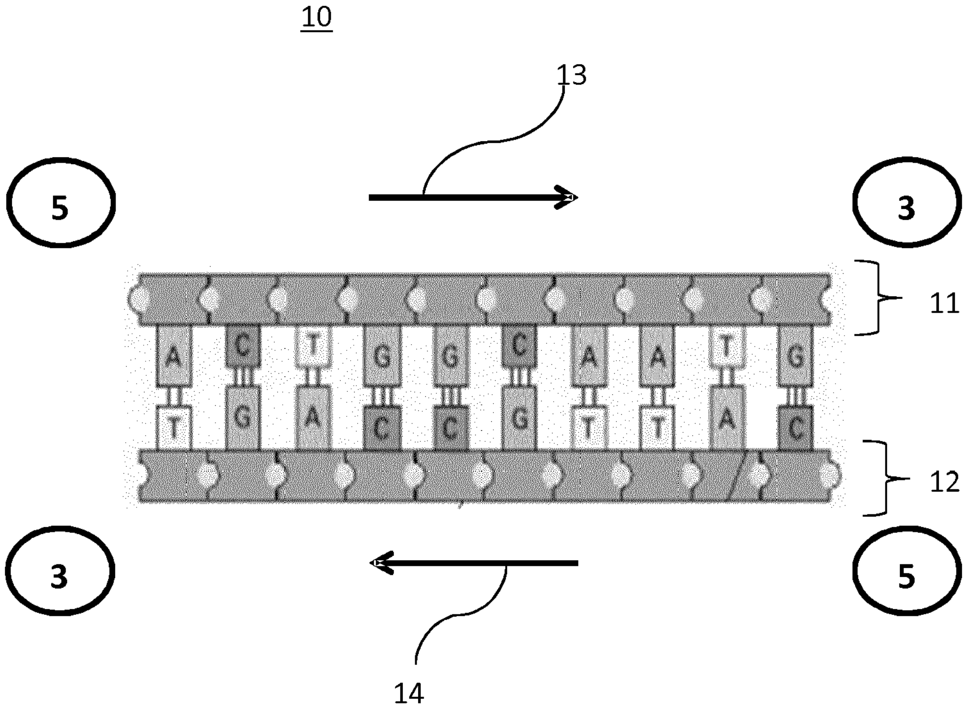


Fig. 1

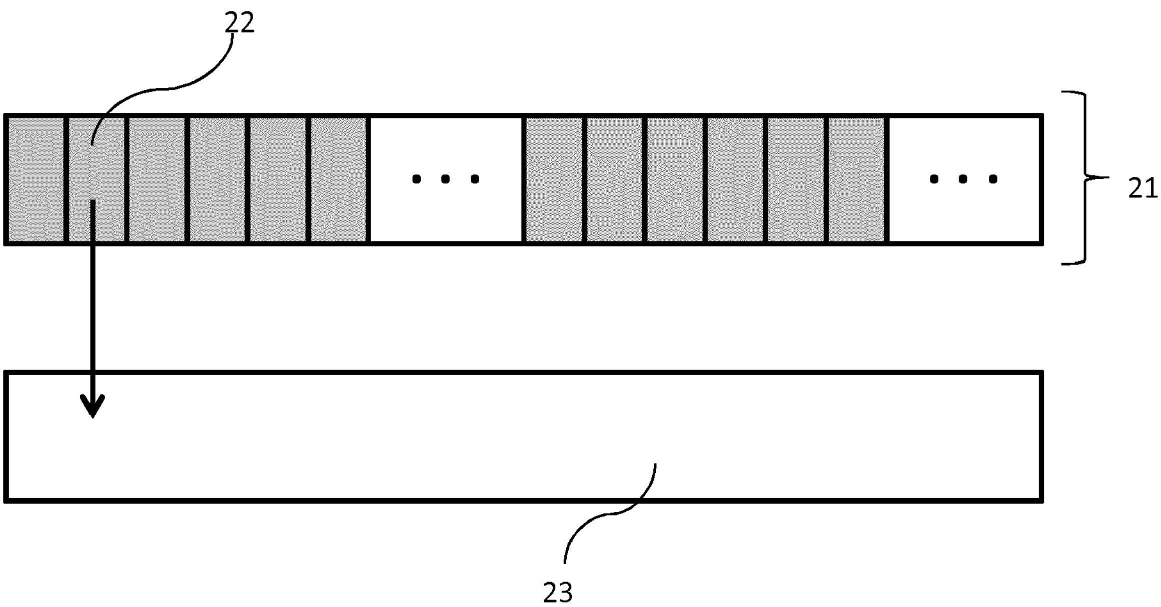


Fig. 2

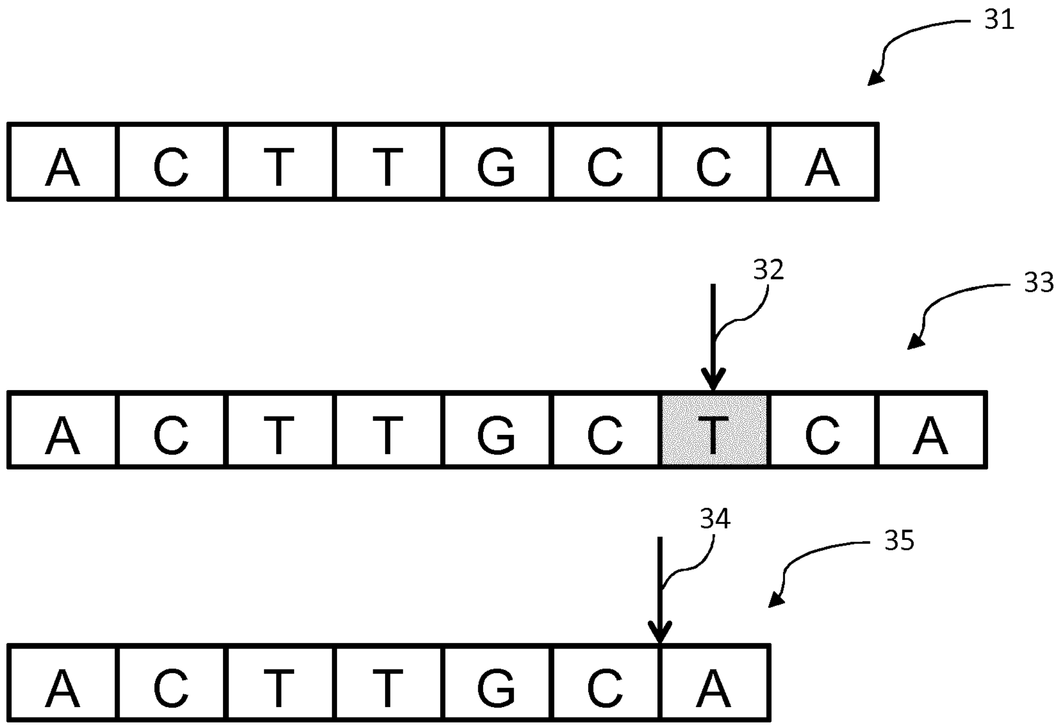
31
A
C
T
T
G
C
C
A
32
33
A
C
T
T
G
C
T
C
A
34
35
A
C
T
T
G
C
A

**Fig. 3**

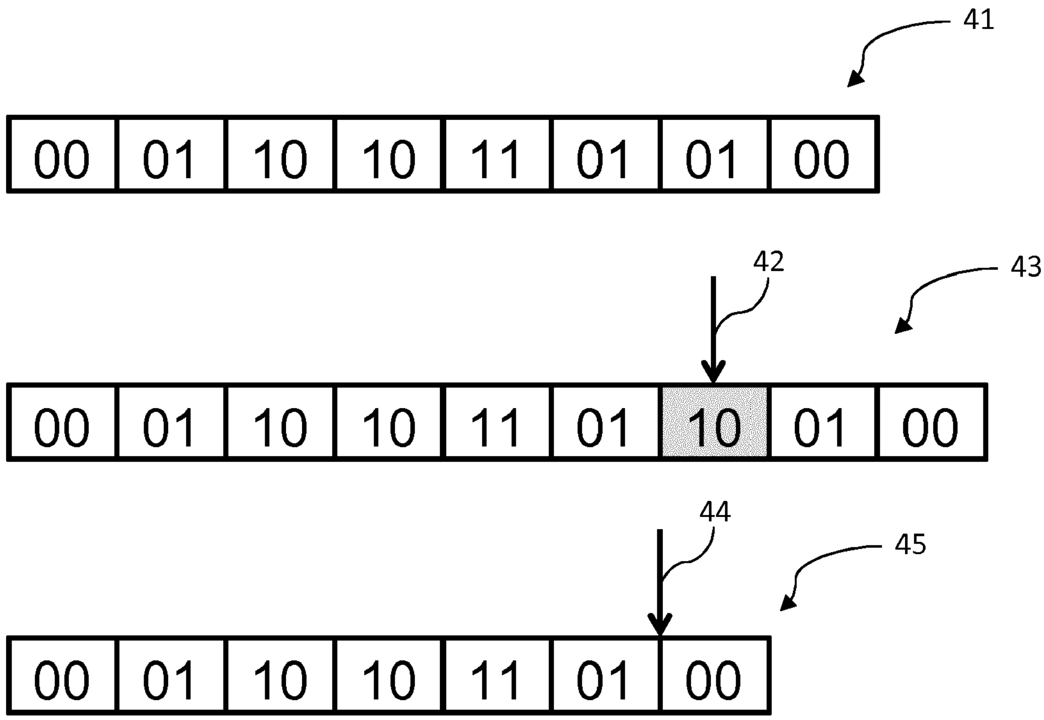
41
00
01
10
10
11
01
01
00
42
43
00
01
10
10
11
01
10
01
00
44
45
00
01
10
10
11
01
00

**Fig. 4**

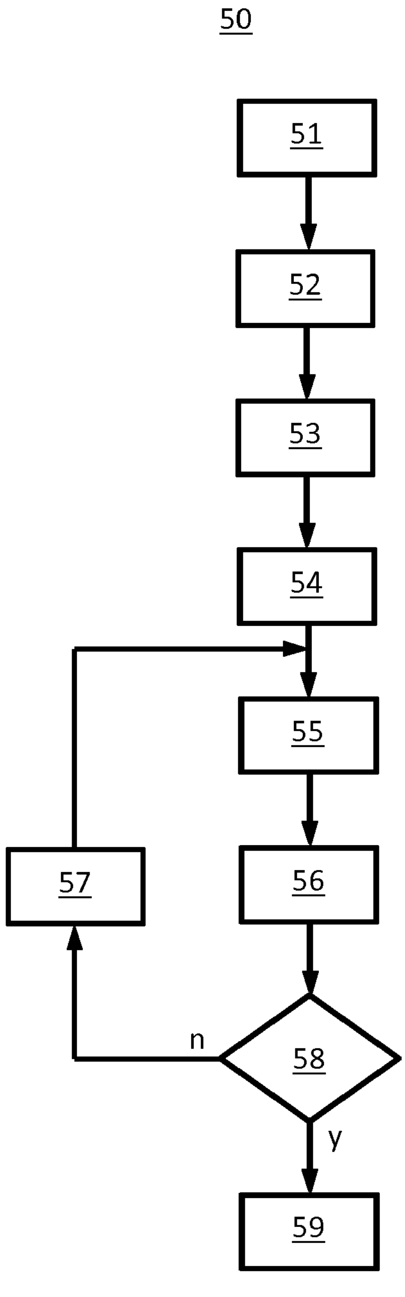


Fig. 5

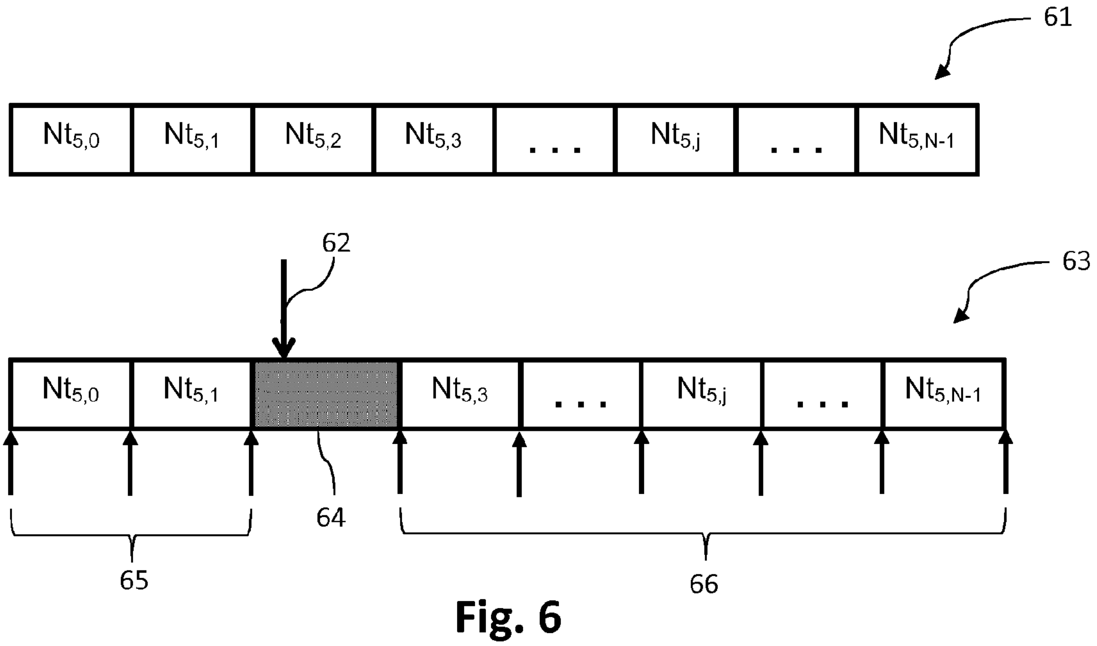
61
Nt5,0
Nt5,1
Nt5,2
Nt5,3
. . .
Nt5,j
. . .
Nt5,N-1
62
63
64
65
66

**Fig. 6**

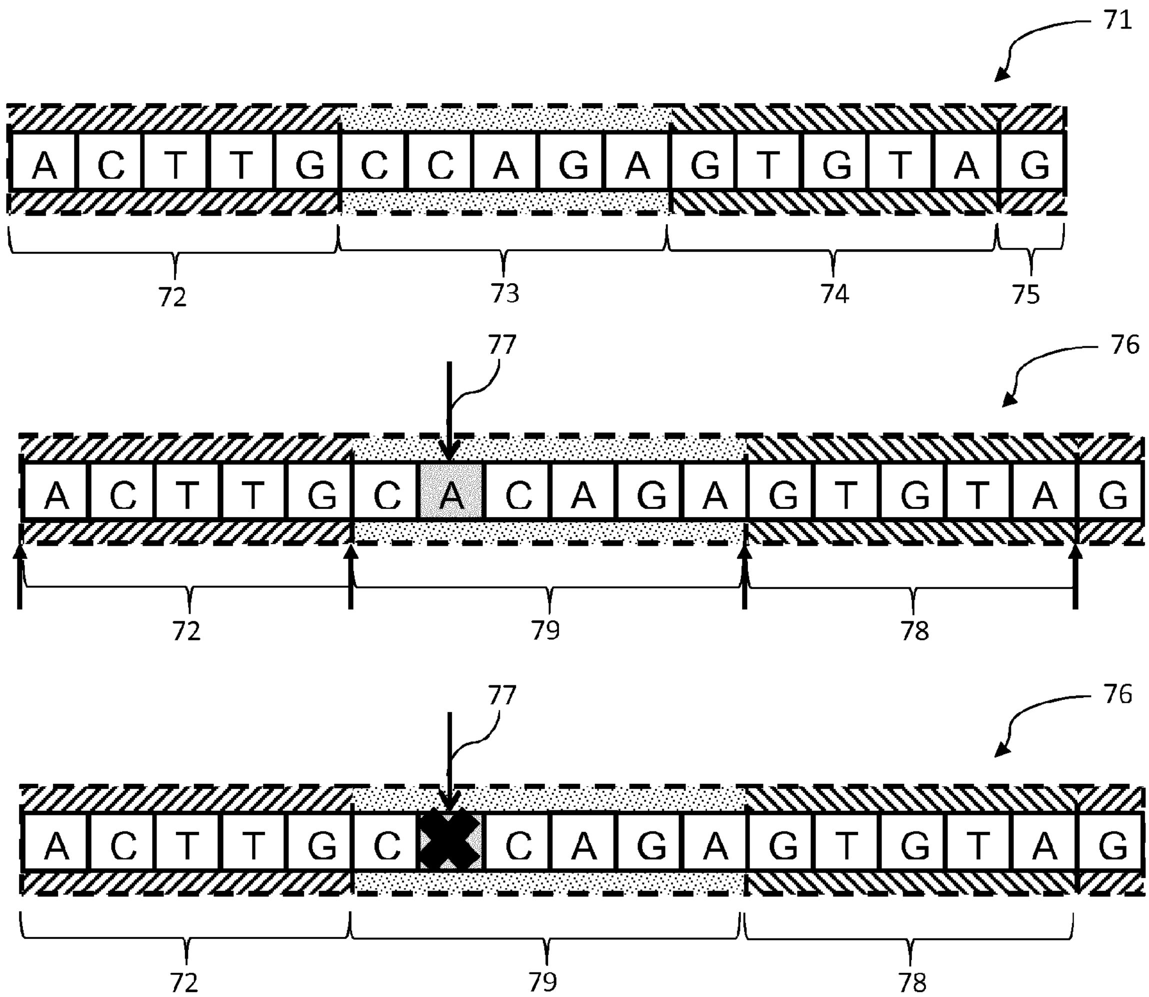
71
A C T T G C C A G A G T G T A G
72
73
74
75
76
77
A C T T G C A C A G A G T G T A G
72
79
78
76
77
A C T T G C C A G A G T G T A G
72
79
78

**Fig. 7**

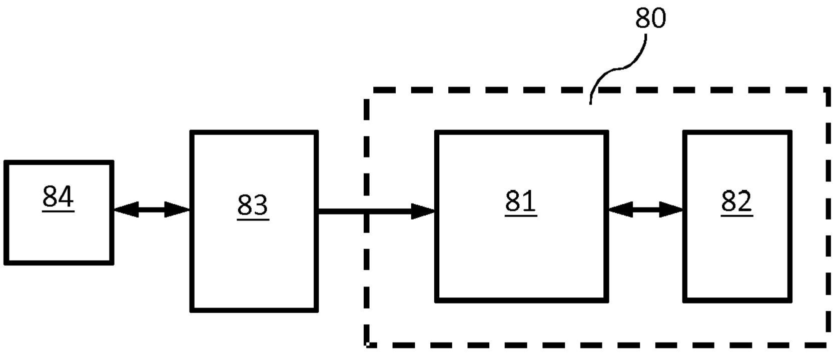


Fig. 8

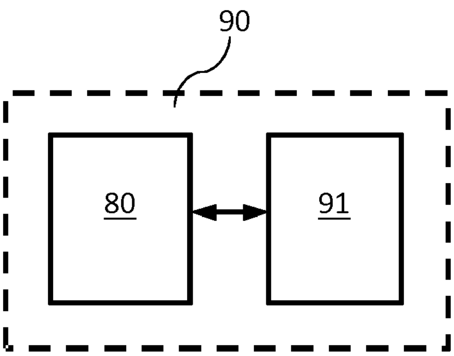


Fig. 9

Europäisches Patentamt
European Patent Office
Office européen des brevets

# EUROPEAN SEARCH REPORT

Application Number
EP 15 30 6666

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Blahut: "Algebraic codes for data transmission", 2006, Cambridge university press, XP002756383, pages 7-8, * the whole document * ----- | 1-15 | INV. H03M7/14 H03M13/33 H03M13/37 |
| X | "Linear Block Codes" In: I. S. Reed, X. Chen: "Error-Control coding for data networks", June 1999 (1999-06), Kluwer, XP002756384, pages 73-75, * paragraph [0003] * ----- | 1-15 | |
| X | Anonymous: "Self-synchronizing code", Wikipedia, the free encyclopedia , 31 July 2015 (2015-07-31), XP002756385, Retrieved from the Internet: URL:https://en.wikipedia.org/w/index.php?title=Self-synchronizing_code&oldid=673938273 [retrieved on 2016-04-13] * the whole document * ----- | 1-15 | |
| | | | TECHNICAL FIELDS SEARCHED (IPC) |
| | | | H03M |

The present search report has been drawn up for all claims

2

| Place of search | Date of completion of the search | Examiner |
|---|---|---|
| The Hague | 13 April 2016 | Rydyger, Kay |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **CHURCH et al.** Next-generation digital information storage. *Science,* 2012, vol. 337, 1628
- **GOLDMAN et al.** Towards practical, high-capacity, low-maintenance information storage in synthesized DNA. *Nature,* 2013, vol. 494
- **GEORGE M. CHURCH ; YUAN GAO ; SRIRAM KOSURI.** Next-Generation Digital Information Storage in DNA. *Science,* 28 September 2012, vol. 337
- **NICK GOLDMAN et al.** Towards practical, high-capacity, low-maintenance information storage in synthesized DNA. *Nature,* January 2013, vol. 494

SEQUENCE LISTING

<110> Thomson Licensing

<120> Data Processing Method and Device for Recovering Valid Code Words from a Corrupted Code Word Sequence

<130> PD140073-EPA

<140> EP15306666.7
<141> 2015-10-19

<160> 5

<170> BiSSAP 1.3

<210> 1
<211> 10
<212> DNA
<213> Artificial Sequence

<220>
<223> Example DNA fragment shown in Fig. 1, ref. num. 11 - first strand, direction 5-3

<400> 1
actggcaatg 10

<210> 2
<211> 10
<212> DNA
<213> Artificial Sequence

<220>
<223> Example DNA fragment shown in Fig. 1, ref. num. 12 - second strand, direction 3-5

<400> 2
tgaccgttac 10

<210> 3
<211> 16
<212> DNA
<213> Artificial Sequence

<220>
<223> Example sequence shown in Fig. 7, ref. num. 71 - initially error-free

<400> 3
acttgccaga gtgtag 16

<210> 4
<211> 17
<212> DNA
<213> Artificial Sequence

<220>
<223> Example sequence shown in Fig. 7, ref. num. 76 - with insertion error

```
<400> 4
acttgcacag agtgtag                                                    17


<210> 5
<211> 16
<212> DNA
<213> Artificial Sequence

<220>
<223> Example sequence shown in Fig. 7, ref. num. 76 – with removed
      insertion error

<400> 5
acttgccaga gtgtag                                                     16
```